# EUROPEAN PATENT SPECIFICATION

(11) **EP 0 373 880 B1**
(45) Date of publication and mention of the grant of the patent: **16.04.1997**
(21) Application number: 89312964.3
(22) Date of filing: 12.12.1989
(51) Int. Cl.: H01L 21/68, H01L 21/00, H01L 21/60, B23K 20/00

(54) **A method of die-bonding pellets**
Verfahren zum Druckbonden von Pellets
Méthode pour fixer des pastilles sous pression

(30) Priority: 12.12.1988 JP 314247/88
(43) Date of publication of application: 20.06.1990
(73) Proprietor: ROHM CO., LTD., Kyoto 615 (JP)
(72) Inventor: Hamaie, Buji, Hiroshima-ken, 722-22 (JP); Ago, Kyoichi, Okayama-ken, 713 (JP); Hatano, Kazufumi, Okayama-ken, 709-12 (JP)
(74) Representative: Bayliss, Geoffrey Cyril

(56) References cited:
- WO-A-85/03405
- PATENT ABSTRACTS OF JAPAN vol. 8, no. 127 (E-250)(1564) 14 June 1984, & JP-A-59 40542 (HITACHI IRUMA DENSHI) 06 March 1984,
- PATENT ABSTRACTS OF JAPAN vol. 10, no. 35 (E-380)(2092) 12 February 1986, & JP- A-60 193357 (FUJITSU) 01 October 1985,

## Description

The present invention relates to a method of a die-bonding.

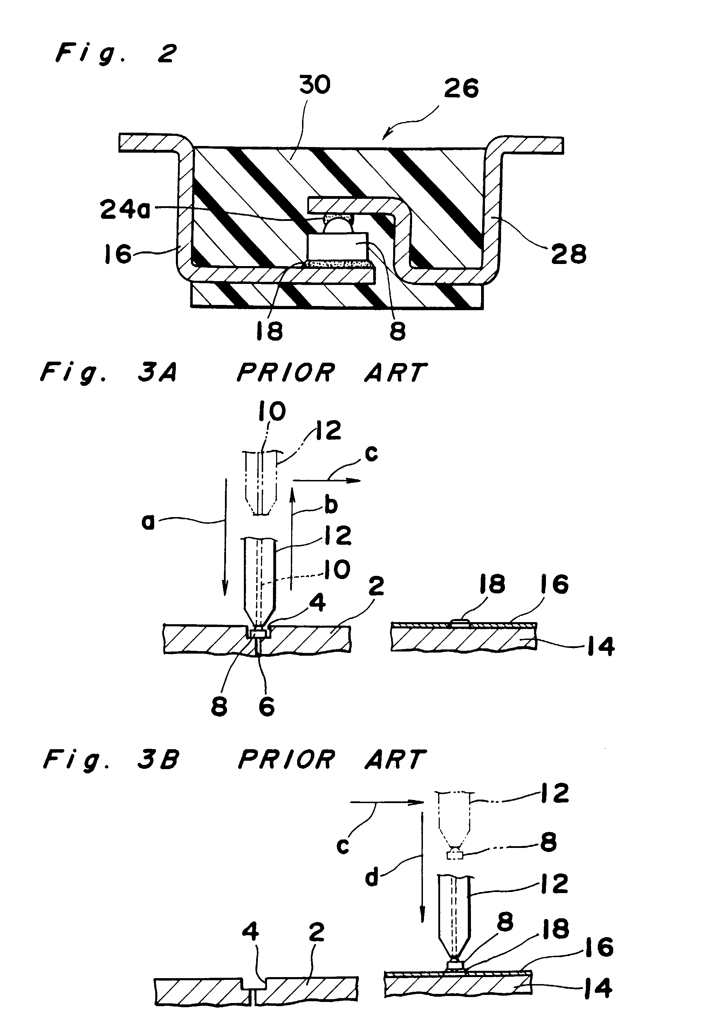

Referring to Figures 3A and 3B of the accompanying drawings, a conventional method of die-bonding pellets will be described hereinafter.

In the first place, as shown in Figure 3A, a needle 12 having a through-bore 10 for suction is brought into contact with an upper portion or bump portion of a pellet 8 (a diode with a bump at its upper portion in this example) located at a first position. The pellet 8 is accommodated within a recess 4 of a pellet holding jig 2, through suction by way of a through-bore 6 formed at the bottom portion of the recess 4. The needle 12 is lowered from an imaginary line position to a position shown by a solid line in the direction of the arrow A, whereby the pellet 8 is held on the forward end of the needle 12, in which state, the needle 12 is raised in a direction indicated by an arrow B. Subsequently, the needle 12 is horizontally moved in a direction indicated by an arrow C, that is towards an adhesive paste 18 applied at a predetermined portion of a frame 16 disposed on a base 14 at a second position, and then, as shown in Figure 3B, the needle 12 is lowered in the direction of the arrow D from the imaginary line position shown by the two-dotted chain line to the solid line position, thereby to bring the pellet 8 held on the forward end of the needle 12, into contact with the adhesive paste 18. Thereafter, the pellet 8 is caused to adhere to the paste 18 by releasing the suction in the through-bore 10 of the needle 12, and thus die-bonding of the pellet 8 onto the frame 16 is completed.

In the known die-bonding practice as described so far, however, there has been a problem that, since it is required to subject the through-bore 10 of the needle 12 to suction, and also to effect a timing control for the suction, as the number of pellets to be die-bonded increases, suction systems corresponding in number to such an increase becomes necessary, and as a result, the arrangement on the whole is extremely complicated, with a consequent rise in cost.

Another problem inherent in the conventional die-bonding method is that, when the needle 12, in a state where no pellet 8 is held by suction to its forward end, is lowered with respect to the paste 18 in the direction of the arrow D in Figure 3B and the forward end thereof contacts the paste 18, there is a possibility that the through-bore 10 of the needle 12 is undesirably closed or clogged by the paste 18. A detecting control system for detecting whether or not any pellet 8 is held on the forward end of the needle 12, and so forth, is also required. From such a point, not only complication and high cost of the entire arrangement are involved, but the possibility of clogging the forward end of the needle 12 by such contact will markedly reduce the reliability of the die-bonding arrangement.

JP-A-5940542 discloses a bonding method corresponding to the preamble of the claim.

Accordingly, an object of the present invention is to provide a method of die-bonding pellets or the like, which is advantageous in terms of simplicity, cost and reliability.

Another object of the present invention is to provide a die-bonding method as described above, which may be readily introduced into various production lines in an efficient manner.

This invention provides a method of die-bonding pellets, which comprises: causing a first paste to adhere to a forward end of a pellet handling means, lowering the pellet handling means from above a pellet located at a first position so as to cause the first paste stuck to the forward end of the pellet handling means to adhere to the upper portion of the pellet, so that the pellet is held at the forward end of the pellet handling means by the adhesive force of the first paste, lowering the pellet held by the first paste at the forward end of the pellet handling means, onto a predetermined portion of a frame applied with a second paste, and then raising the pellet handling means so as to leave the pellet adhered to the frame by the second paste; wherein the pellet handling means is in the form of a needle having a forward end to which said first paste is adhered to a smaller area than the applied area of the second paste whereby the pellet remains adhered to the frame by the second paste when the needle is raised.

Thus in the die-bonding method of the present invention, the suction device is dispensed with and since no through-bore within the needle is required, the die-bonding arrangement may be simplified in construction on the whole, with a consequent reduction in cost. Since there is no through-bore to be clogged by the second paste, the control system for detecting such clogging is dispensed with. Therefore, from this aspect also, the whole arrangement can be further simplified and reduced in cost, while the reliability of its functioning may be improved to a large extent.

The following is a description of a specific embodiment of the invention, reference being made to the accompanying drawings, in which:
Figures 1A to 1D are fragmentary side sectional diagrams for explaning the steps of a method of die-bonding pellets;
Figure 2 is a side sectional view showing a general construction of a diode, and
Figures 3A and 3B are diagrams similar to those of Figures 1A to 1D, which are particularly related to a conventional die-bonding method (already referred to).

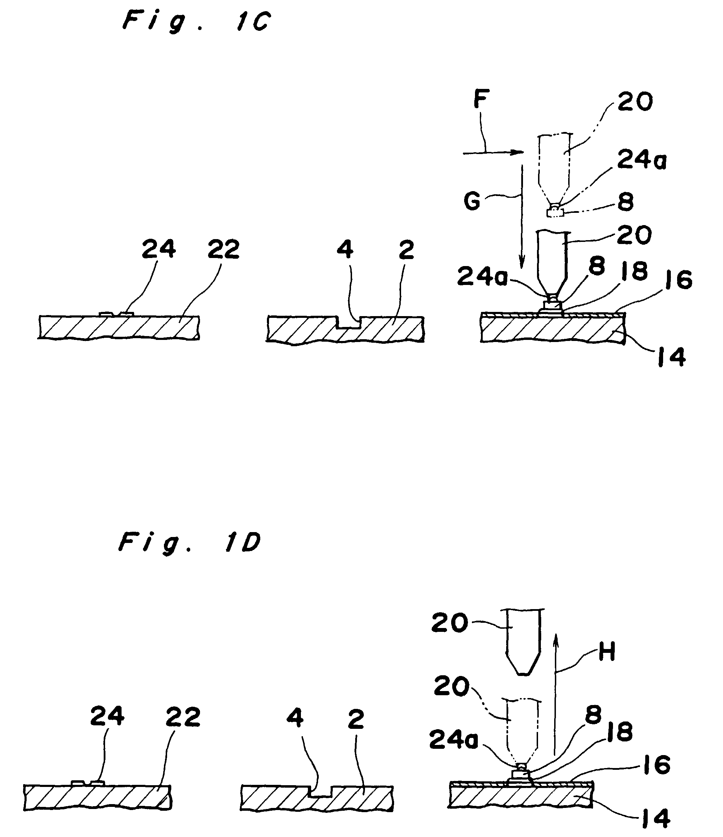

Referring now to the drawings, a method of die-bonding pellets will be explained with reference to Figures 1A to 1D.

In the die-bonding method of the present invention a needle 20 is used which is not provided with a suction through-bore therein as in the conventional arrangement described earlier with reference to Figures 3A and 3B.

In a first step of the die-bonding method, as shown in Figure 1A, the needle 20 is lowered in the direction indicated by the arrow A from an imaginary line position shown by a two-dotted chain line to a position indicated by a solid line position so as to bring the forward end of the needle 20 into contact with a first adhesive paste 24 placed on a base 22. Thereby a part (referred to as adhering or stuck paste 24a hereinafter) of the first paste 24 is caused to adhere to the forward end, and then the needle 20 is raised in the direction of the arrow B for subsequent displacement in the horizontal direction indicated by the arrow C.

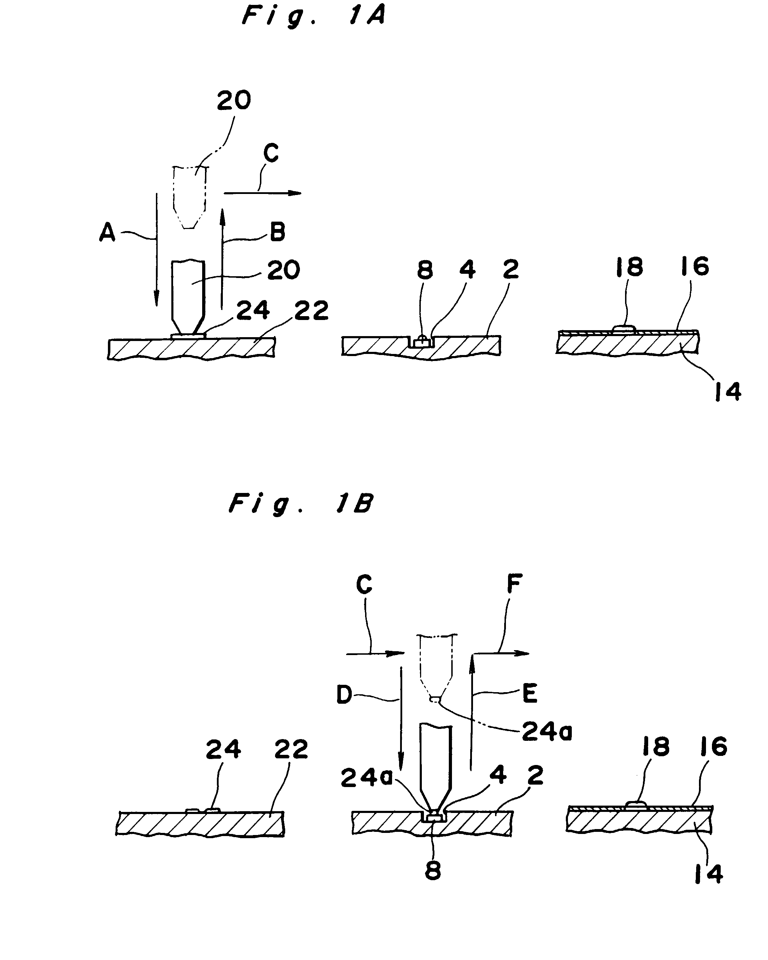

In a second step, at a first position in the direction C for the horizontal displacement of the needle 20, as shown in Figure 1B, the needle 20 is lowered in the direction of the arrow D from above a pellet 8 accommodated within a recess 4 of a holding jig 2 so as to bring the forward end of the needle 20 into contact with the upper portion of the pellet 8. Thus, the paste 24a stuck to the forward end of the needle 20 in the first step is caused to adhere to the bump portion at the upper portion of the pellet 8. Then, the needle 20 is raised in the direction of the arrow E, with the pellet 8 held at the forward end thereof by the above adhesion, and is then horizontally displaced in the direction of the arrow F to a second position.

Subsequently, in a third step, as shown in Figure 1C, the lower portion of the pellet 8, held at the forward end of the needle 20 by the stuck paste 24a in the second step, is lowered in the direction of the arrow G onto a predetermined portion of a frame 16 supported on a base 14 and to which a second adhesive paste 18 has been applied for contact with the pellet 8, with the stuck paste 24a at the forward end of the needle 20 contacting the bump portion of the pellet 8.

Finally, in a fourth step, the needle 20 is raised in the direction of the arrow H as shown in Figure 1D. In this case, since the applied area of the second paste 18 is larger than that of the stuck paste 24a, when the needle 20 is raised in the direction of the arrow H, there is no possibility that the pellet 8 is lifted together with the needle 20 but instead remains adhered to the frame 16 by the second paste 18.

As is seen from the above description, the suction through-bore conventionally required is dispensed with in the construction of the needle 20 itself, and consequently, neither a suction device nor control device for the timing of the suction is necessary.

Referring now to Figure 2, there is shown a general construction of a diode 26 manufactured based on the die-bonding method according to the steps as described so far.

In Figure 2, the diode 26 shown in Figure 2 has the lower portion of the pellet 8 die-bonded onto the paste 18 of the terminal frame 16, with a terminal frame 28 being fixed to the stuck paste 24a on the upper portion of the pellet 8, and both of the terminal frames 16 and 28 are extended outwardly, from a resin mold portion 30 which covers the assembly, so as to provide external terminals or leads.

In the diode 26 having the construction as described above, since the stuck paste 24a is initially present on the bump portion at the upper portion of the pellet 8, it is unnecessary to particularly provide a bonding agent for the bonding of the bump portion of the diode and the terminal frame 28.

## Claims

1. A method of die-bonding pellets, which comprises: causing a first adhesive paste (24a) to adhere to a forward end of a pellet handling means (20), lowering the pellet handling means (20) from above a pellet (8) located at a first position so as to cause the first paste (24a) stuck to the forward end of the pellet handling means (20) to adhere to the upper portion of the pellet (8), so that the pellet (8) is held at the forward end of the pellet handling means (20) by the adhesive force of the first paste (24a), raising said pellet handling means and displacing it to a second position, lowering the pellet (8) held by the first paste (24a) at the forward end of the pellet handling means (20), onto a predetermined portion of a frame (16) applied with a second adhesive paste (18), and then raising the pellet handling means (20) so as to leave the pellet (8) adhered to the frame (16) by the second paste (18); characterised in that the pellet handling means is in the form of a needle (20) having a forward end to which said first paste (24a) is adhered to with a smaller area than the applied area of the second paste (18) whereby the pellet remains adhered to the frame by the second paste when the needle is raised.

## Patentansprüche

1. Verfahren zum Druckbonden von Pellets, welches umfaßt: Anhaftenlassen einer ersten Klebepaste (24a) am Vorderende eines Pellethalters (20), Absenken des Pellethalters (20) von oberhalb eines Pellets (8), das sich an einer ersten Position befindet, so daß die am Vorderende des Pellethalters (20) angeklebte erste Paste (24a) am oberen Teil des Pellets (8) anhaftet, so daß das Pellet (8) durch die Klebekraft der ersten Paste (24a) am Vorderende des Pellethalters (20) gehalten wird, Anheben des Pellethalters und Bewegen desselben in eine zweite Position, Absenken des von der ersten Paste (24a) am Vorderende des Pellethalters (20) gehaltenen Pellets (8) auf einen vorbestimmten Teil eines Rahmens (16), an dem eine zweite Klebepaste (18) aufgebracht ist, und anschließendes Anheben des Pellethalters (20), so daß das Pellet (8) durch die zweite Paste (18) am Rahmen (16) haftenbleibt,
dadurch **gekennzeichnet**, daß der Pellethalter die Form einer Nadel (20) hat, deren Vorderende, an dem die erste Paste (24a) zum Anhaften gebracht ist, eine kleinere Fläche als die Auftragungsfläche der zweiten Paste (18) hat, wodurch das Pellet durch die zweite Paste am Rahmen haftenbleibt, wenn die Nadel angehoben wird.

## Revendications

1. Procédé de fixation en matrice de pastilles qui comprend les phases consistant à : faire adhérer une première pâte adhésive (24a) à une extrémité avant d'un moyen de manipulation des pastilles (20), abaisser le moyen de manipulation des pastilles (20) d'un point situé au-dessus d'une pastille (8) placée dans une première position, de manière à faire adhérer la première pâte (24a) collée à l'extrémité avant du moyen de manipulation des pastilles (20) à la partie supérieure de la pastille (8), de manière que la pastille (8) soit retenue à l'extrémité avant du moyen de manipulation des pastilles (20) par la force adhésive de la première pâte (24a), relever ledit moyen de manipulation des pastilles et le transporter à une deuxième position, abaisser la pastille (8) retenue par la première pâte (24a) à l'extrémité avant du moyen de manipulation des pastilles (20) sur une partie prédéterminée d'un cadre (16) enduit d'une deuxième pâte (18), puis relever le moyen de manipulation des pastilles (20) de manière à laisser la pastille (8) collée au cadre (16) par la deuxième pâte (18) ; caractérisé en ce que le moyen de manipulation des pastilles est réalisé sous la forme d'une aiguille (20) ayant une extrémité avant à laquelle ladite première pâte (24a) est collée sur une surface plus petite que la surface enduite de la deuxième pâte (18), de sorte que la pastille reste collée au cadre par la deuxième pâte lorsque l'aiguille est relevée.
